# EUROPEAN PATENT APPLICATION

(11) **EP 3 520 906 A1**
(43) Date of publication of application: **07.08.2019**
(21) Application number: 17855649.4
(22) Date of filing: 07.09.2017
(51) Int. Cl.: B05D 1/42, H01L 21/336, H01L 29/786, H01L 51/40, H01L 51/48

(54) **PRODUCTION METHOD FOR FILM**

(30) Priority: 27.09.2016 JP 2016187918
(71) Applicant: FUJIFILM Corporation, Tokyo 106-8620 (JP)
(72) Inventor: NAKAMURA Seigo, Ashigara-kami-gun Kanagawa 258-8577 (JP); YAEGASHI Hiroyuki, Ashigara-kami-gun Kanagawa 258-8577 (JP)
(74) Representative: Hoffmann Eitle
(86) International application number: PCT/JP2017/032216
(87) International publication number: WO 2018/061691

(57) **Abstract**

Provided is a method of producing a high-quality film having a thin film and high uniformity in film thickness or the like. The method of producing a film includes supplying a raw material solution containing a solvent and a material that forms a film onto a substrate and drying the solvent to form the film on the substrate. A coating blade holding the raw material solution on the substrate is used, and the coating blade has a facing surface which faces a surface of the substrate and at least one side surface which is provided in the periphery of the facing surface and is in contact with the raw material solution. The solvent of the raw material solution is dried along a specific direction to form the film.

## Description

### BACKGROUND OF THE INVENTION

### 1. Field of the Invention

The present invention relates to a method of producing a film according to a coating method and particularly relates to a method of producing a film formed of an organic semiconductor material, a crystal material, an alignment material, and the like.

### 2. Description of the Related Art

Currently, organic semiconductors have been expected as a semiconductor material used for flexible devices and the like. One of the features of organic semiconductors is that the organic semiconductors can be formed by performing coating at a low temperature, compared to inorganic semiconductors such as silicon. Various methods of producing an organic semiconductor film obtained by using organic semiconductors have been suggested.

JP5397921B describes a method of producing an organic semiconductor film according to a coating method using an organic semiconductor material.

According to the method of producing an organic semiconductor film in JP5397921B, a wedge-like gap is provided between a contact surface and a surface of a substrate, and liquid droplets of a raw material solution are held in a space between the surface of the substrate and the contact surface at the time of forming a state in which liquid droplets are held. In this state, the raw material solution is supplied so as to come into contact with the contact surface. A drying process is performed in a state in which the liquid droplets are held by the contact surface so that the solvent in the liquid droplets is evaporated. The crystallization of the organic semiconductor material is promoted simultaneously with the evaporation of the solvent, and crystal growth progresses toward the closed side of the contact surface to gradually form an organic semiconductor film.

WO2016/031968A describes a method of producing a semiconductor film. WO2016/031968A describes an edge cast method of coating a surface of a gate insulating film formed on a gate electrode.

According to the edge cast method, a nozzle and a blade are disposed on the gate insulating film. A coating solution is supplied from the nozzle to an edge portion facing the surface of the gate insulating film on which the blade is disposed. The nozzle and the substrate are held at a temperature at which the solvent is evaporated. The substrate is moved in one direction while the coating solution is continuously supplied such that the amount of the coating solution held by the edge portion becomes constant. The organic semiconductor material is crystallized as the solvent in the coating solution supplied from the nozzle is evaporated.

### SUMMARY OF THE INVENTION

An organic semiconductor film can be formed using any of the method of producing an organic semiconductor film in JP5397921B or the method of producing a semiconductor film in WO2016/031968A. However, in regard to an organic semiconductor film, further reduction in film thickness and uniformity in film thickness or the like have been required currently.

An object of the present invention is to solve the problems caused by the techniques of the related art described above and to provide a method of producing a high-quality film having a thin film and high uniformity in film thickness or the like.

In order to achieve the above-described object, the present invention provides a method of producing a film, comprising: supplying a raw material solution containing a solvent and a material that forms a film onto a substrate and drying the solvent to form the film on the substrate, in which a coating blade holding the raw material solution on the substrate is used, the coating blade has a facing surface which faces a surface of the substrate and at least one side surface which is provided in the periphery of the facing surface and is in contact with the raw material solution, and the solvent of the raw material solution is dried along a specific direction to form the film.

It is preferable that at least three surfaces, which are the facing surface and two side surfaces of the coating blade, are in contact with the raw material solution.

Further, it is preferable that the specific direction in which the raw material solution is dried is determined by at least one surface from among the facing surface and at least two side surfaces of the coating blade.

Further, it is preferable that the specific direction in which the raw material solution is dried is determined only by one surface from among the facing surface and at least two side surfaces of the coating blade. Further, it is preferable that the specific direction in which the raw material solution is dried is determined only by the facing surface of the coating blade.

It is preferable that the coating blade has two side surfaces, and two side surfaces are respectively perpendicular to the surface of the substrate and provided so as to face each other.

It is preferable that the facing surface of the coating blade is inclined with respect to the surface of the substrate. It is preferable that a tilt angle of the facing surface of the coating blade with respect to the surface of the substrate is in a range of 1° to 6°.

It is preferable that a film growth interface of the raw material solution held on the substrate by the coating blade is curved toward the center of the raw material solution.

Further, it is preferable that a position of the coating blade is fixed to the surface of the substrate.

The coating blade may include an open part that opens at least a part in the periphery of the raw material solution and the substrate may be moved in a direction toward the open part from the center of the raw material solution.

In this case, it is preferable that the substrate is moved while the raw material solution is supplied to a space between the surface of the substrate and the coating blade so that the film is continuously formed.

It is preferable that, in a case where a boiling point of the solvent of the raw material solution is set as Tb°C and a substrate temperature is set as Ts°C, the substrate temperature Ts is held at a temperature satisfying an expression of "Tb - 50°C ≤ Ts ≤ Tb".

The film is formed of a material having an aligning property. For example, the material having an aligning property is a material or an organic semiconductor that forms a crystal.

According to the present invention, it is possible to obtain a high-quality film having a thin film and high uniformity in film thickness or the like.

### BRIEF DESCRIPTION OF THE DRAWINGS

Fig. 1 is a schematic perspective view illustrating a coating blade used for a method of producing a film according to an embodiment of the present invention.
Fig. 2 is a schematic view illustrating the coating blade used for the method of producing a film according to the embodiment of the present invention.
Fig. 3 is a view obtained by enlarging main parts of one end portion of the coating blade used for the method of producing a film according to the embodiment of the present invention.
Fig. 4 is a view obtained by enlarging main parts of the other end portion of the coating blade used for the method of producing a film according to the embodiment of the present invention.
Fig. 5 is a schematic plan view illustrating the coating blade used for the method of producing a film according to the embodiment of the present invention.
Fig. 6 is a schematic view illustrating a side surface of the coating blade used for the method of producing a film according to the embodiment of the present invention.
Fig. 7 is a schematic view illustrating one step in a first example of the method of producing a film according to the embodiment of the present invention.
Fig. 8 is a schematic view illustrating one step in the first example of the method of producing a film according to the embodiment of the present invention.
Fig. 9 is a schematic cross-sectional view illustrating an example of a thin film transistor to be produced using the method of producing a film according to the embodiment of the present invention.
Fig. 10 is a schematic cross-sectional view illustrating a first example of a position where a supply port of a supply pipe in the coating blade used for the method of producing a film according to the embodiment of the present invention is disposed.
Fig. 11 is a schematic cross-sectional view illustrating a second example of the position where the supply port of the supply pipe in the coating blade is disposed.
Fig. 12 is a schematic cross-sectional view illustrating a third example of the position where the supply port of the supply pipe in the coating blade is disposed.
Fig. 13 is a schematic view illustrating an example of disposition of a film to be formed according to the method of producing a film according to the embodiment of the present invention.
Fig. 14 is a schematic view illustrating one step in a second example of the method of producing a film according to the embodiment of the present invention.
Fig. 15 is a schematic view illustrating one step in the second example of the method of producing a film according to the embodiment of the present invention.
Fig. 16 is a schematic view illustrating one step in the second example of the method of producing a film according to the embodiment of the present invention.
Fig. 17 is a schematic view illustrating one step in the second example of the method of producing a film according to the embodiment of the present invention.
Fig. 18 is a schematic view illustrating a first example of a production device used for the method of producing a film according to the embodiment of the present invention.
Fig. 19 is a schematic view for describing a third example of the method of producing a film according to the embodiment of the present invention.
Fig. 20 is a plan view for describing the third example of the method of producing a film according to the embodiment of the present invention.
Fig. 21 is a schematic view illustrating a second example of the production device used for the method of producing a film according to the embodiment of the present invention.
Fig. 22 is a schematic view illustrating a coating blade used in an example.
Fig. 23 is a schematic cross-sectional view illustrating the coating blade used in the example.
Fig. 24 is a schematic view illustrating a coating blade used in a comparative example.
Fig. 25 is a schematic cross-sectional view illustrating the coating blade used in the comparative example.
Fig. 26 is a schematic view showing a measuring region of a film thickness and a saturation mobility.
Fig. 27 is a schematic view showing the film in Example 1.
Fig. 28 is a schematic view showing the film in Comparative Example 1.

### DESCRIPTION OF THE PREFERRED EMBODIMENTS

Hereinafter, a method of producing a film according to the embodiment of the present invention will be described in detail based on preferred embodiments illustrated in the accompanying drawings.

Further, hereinafter, "to" indicating the ranges of numerical values includes numerical values described on both sides. For example, the expression "ε is in a range of a numerical value α to a numerical value β" means that the range of ε is a range including the numerical value α and the numerical value β and satisfies an expression "α ≤ ε ≤ β" shown using the mathematical symbols.

Angles such as "an angle represented by a specific numerical value", "parallel", "perpendicular", and "orthogonal" include error ranges typically accepted in the corresponding technical fields unless otherwise specified.

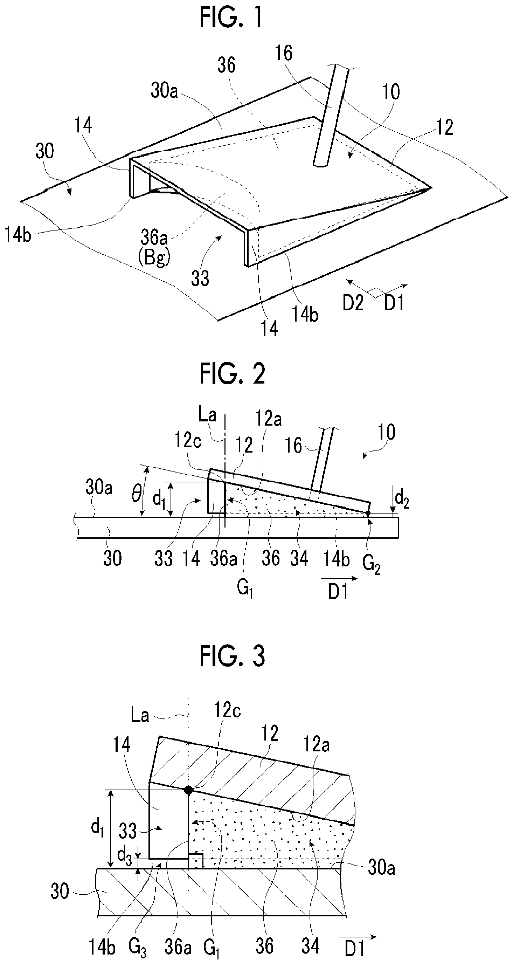

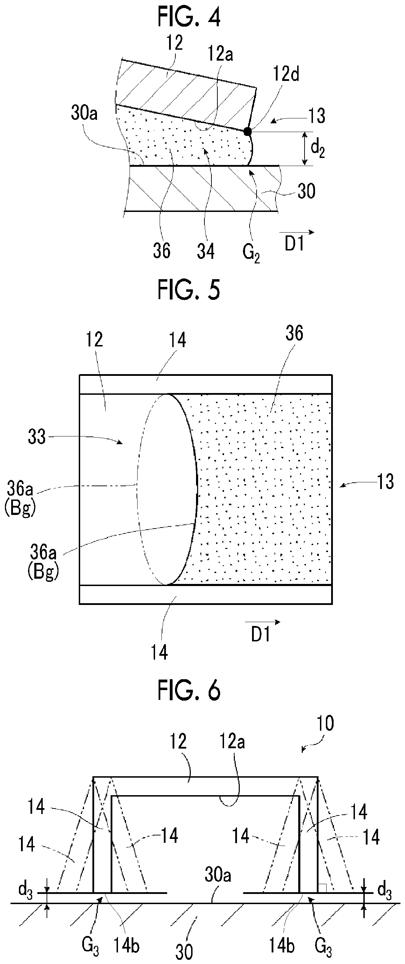

Fig. 1 is a schematic perspective view illustrating a coating blade used for a method of producing a film according to an embodiment of the present invention, Fig. 2 is a schematic view illustrating the coating blade used for the method of producing a film according to the embodiment of the present invention, Fig. 3 is a view obtained by enlarging main parts of one end portion of the coating blade used for the method of producing a film according to the embodiment of the present invention, and Fig. 4 is a view obtained by enlarging main parts of the other end portion of the coating blade used for the method of producing a film according to the embodiment of the present invention.

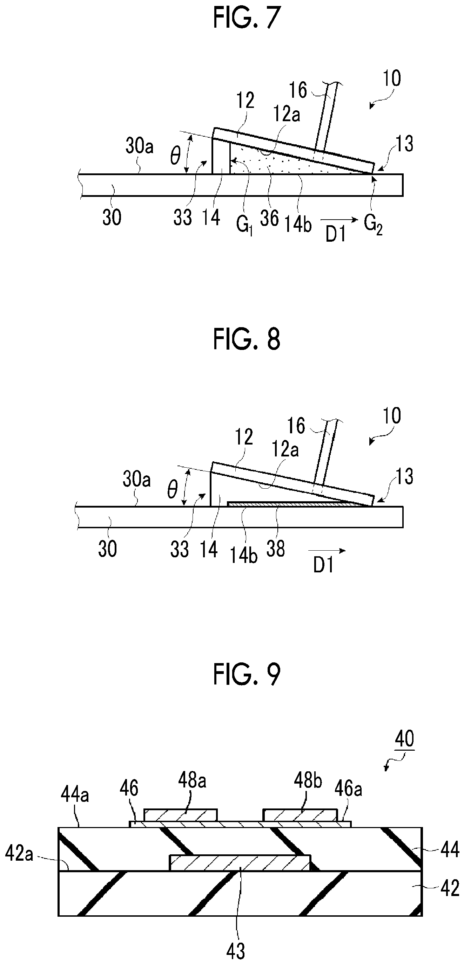

A coating blade 10 illustrated in Figs. 1 to 4 is used for forming a film 38 (see Fig. 8). A raw material solution 36 is held by a substrate 30, that is, a surface 30a of the substrate 30.

The coating blade 10 includes, for example, a plane portion 12 formed of a rectangular flat plate and at least two side surfaces 14 provided on the plane portion 12.

The plane portion 12 includes a facing surface 12a that faces the surface 30a of the substrate 30. For example, two side surfaces 14 are provided in the periphery of the facing surface 12a. In Figs. 1 to 4, the longitudinal direction of the plane portion 12 is set as a first direction D1 and a direction orthogonal to the first direction D1 is set as a second direction D2 (see Fig. 1).

In the coating blade 10, the plane portion 12 is disposed so as to be spaced from the surface 30a of the substrate 30 in a state of facing the surface 30a, and the facing surface 12a of the plane portion 12 is inclined with respect to the surface 30a of the substrate 30. For example, the facing surface 12a is an inclined surface which is monotonically inclined with respect to the surface 30a of the substrate 30.

Further, the facing surface 12a of the coating blade 10 may not be inclined with respect to the surface 30a of the substrate 30, and the facing surface 12a may be in parallel with the surface 30a of the substrate 30.

A tilt angle θ of the facing surface 12a of the coating blade 10 with respect to the surface 30a of the substrate 30 is an angle between the facing surface 12a of the coating blade 10 and the surface 30a of the substrate 30.

For example, the tilt angle θ is preferably in a range of 1° to 6°. The tilt angle θ is more preferably in a range of 3° to 5°. In a case where the tilt angle θ is in a range of 1° to 6°, a proper amount of the raw material solution 36 can be held, and the mobility is high in a case of an organic semiconductor film, and thus the film 38 with an excellent film quality can be obtained.

The length of the coating blade 10 is not particularly limited and is appropriately determined according to the length of a film to be formed. The length of the coating blade 10 is a length of the plane portion 12 in the longitudinal direction in Fig. 1.

The width of the coating blade 10 is not particularly limited and is appropriately determined according to the width of a film to be formed. The width of the coating blade 10 is a length of a direction orthogonal to the longitudinal direction described above, that is, the length of the second direction D2.

Two side surfaces 14 of the coating blade 10 are respectively perpendicular to the surface 30a of the substrate 30 and provided so as to face each other. In the coating blade 10, end surfaces 14b of the side surfaces 14 are disposed to face the surface 30a of the substrate 30. At this time, each end surface 14b of the side surface 14 and the surface 30a of the substrate 30 are disposed with a gap G₃ therebetween. A size d₃ of this gap G₃ is the same as a size d₂ of a second gap G₂ described below.

In the coating blade 10, a supply pipe 16 is provided on the plane portion 12. The raw material solution 36 is supplied through the supply pipe 16, and three surfaces which are the facing surface 12a and two side surfaces 14 of the coating blade 10 come into contact with the raw material solution 36. The surface tension is imparted to the raw material solution 36 due to the facing surface 12a and two side surfaces 14. For example, it is preferable that at least three surfaces which are the facing surface 12a and two side surfaces 14 of the coating blade 10 are in contact with the raw material solution 36.

In the coating blade 10, the raw material solution 36 is held in a region surrounded by the plane portion 12 and the side surfaces 14, and a liquid reservoir 34 of the raw material solution 36 is formed. The liquid reservoir 34 is a region where the facing surface 12a and the side surfaces 14 of the coating blade 10 are in contact with the raw material solution 36.

The facing surface 12a of the coating blade 10 is inclined, a first gap G₁ and the second gap G₂ having a difference in size between separation gaps are formed in the liquid reservoir 34 between the facing surface 12a of the coating blade 10 and the surface 30a of the substrate 30. A size d₁ of the first gap G₁ is larger than the size d₂ of the second gap G₂.

The first gap G₁ is a gap between the surface 30a of the substrate 30 and one end portion of the liquid reservoir 34 in the first direction D1. The second gap G₂ is a gap between the surface 30a and the substrate 30 and the other end portion of the liquid reservoir 34 in the first direction D1. The coating blade 10 is provided with two side surfaces 14 and includes an open part 33 formed such that at least a part in the periphery of the raw material solution 36 is opened. Specifically, in the coating blade 10, the first gap G₁ side between the facing surface 12a and the surface 30a of the substrate 30 is opened, and this opened side forms the open part 33.

As illustrated in Fig. 3, the size d₁ of the first gap G₁ indicates a length between a site 12c and the surface 30a of the substrate 30, which means from the site 12c at which a liquid surface 36a of the raw material solution 36 in the open part 33 of the liquid reservoir 34 is in contact with the facing surface 12a of the coating blade 10 to the surface 30a of the substrate 30 in a straight line La perpendicular to the surface 30a of the substrate 30.

The size d₁ of the first gap G₁ decreases as the raw material solution 36 is dried and finally becomes the same as the size d₂ of the second gap G₂, in a case where film formation is carried out by fixing the coating blade 10. Accordingly, the size d₁ of the first gap G₁ is a standard value at the time of supplying the raw material solution 36.

Since the size d₁ of the first gap G₁ at the time of supplying the raw material solution depends on the length of a film to be formed which is in a range of 0.5 mm to 5 mm, the size d₁ is not limited.

The size d₂ of the second gap G₂ is the minimum distance between the surface 30a of the substrate 30 in the liquid reservoir 34 and the facing surface 12a of the coating blade 10 and the value is 40 µm or less. The facing surface 12a of the coating blade 10 is monotonically inclined with respect to the surface 30a of the substrate 30 as described above. In this case, the length between the surface 30a of the substrate 30 and a corner portion 12d of the coating blade 10 illustrated in Fig. 4 becomes the minimum distance. Accordingly, in the coating blade 10 illustrated in Fig. 2, the size d₂ of the second gap G₂ is the length between the surface 30a of the substrate 30 and the corner portion 12d of the coating blade 10. A range from the above-described site 12c to the above-described corner portion 12d in the facing surface 12a of the coating blade 10 is a range where the coating blade 10 is in contact with the raw material solution 36, and the range from the above-described site 12c to the above-described corner portion 12d is referred to as a solution holding portion.

The size d₁ of the first gap G₁ is obtained by acquiring a digital image including the substrate 30 from the side surface of the coating blade 10, inputting this digital image into a computer, drawing the above-described straight line La on the digital image based on this digital image, and measuring the length between the site 12c of the facing surface 12a and the surface 30a of the substrate 30 on the computer.

The size d₂ of the second gap G₂ is obtained by acquiring a digital image including the substrate 30 from the side surface of the coating blade 10, inputting this digital image into a computer, and measuring the length between the surface 30a of the substrate 30 and the corner portion 12d of the facing surface 12a of the coating blade 10 on the computer based on this digital image.

As described above, the size d₂ of the second gap G₂ is 40 µm or less. In a case where film formation is carried out by fixing the coating blade 10, the lower limit of the size d₂ of the second gap G₂ is 0 µm. In other words, film formation may be carried out in a grounded state. In a case where film formation is carried out by moving the coating blade 10 or the substrate 30, the lower limit of the size d₂ of the second gap G₂ is 10 µm.

The size d₂ of the second gap G₂ is 40 µm or less, occurrence of vibration of the raw material solution 36 is suppressed so that the film quality of the film 38 can be improved. As described below, in a case where the film 38 is formed by moving the substrate 30 or the coating blade 10, occurrence of vibration of the raw material solution 36 in the liquid reservoir 34 can be suppressed, and the moving speed can be increased. Therefore, for example, in a case where a thin film transistor is prepared, a transistor having excellent characteristics can be obtained with high productivity.

Meanwhile, the size d₂ of the second gap G₂ exceeds 40 µm, vibration of the raw material solution 36 in the liquid reservoir 34 occurs, and thus the film quality of the film 38 deteriorates. Consequently, for example, in a case where a thin film transistor is prepared, excellent characteristics cannot be obtained.

Since the upper limits of the size d₁ of the first gap G₁ and the size d₂ of the second gap G₂ are changed depending on the surface energy (the solvent, the material of the coating blade 10, and the surface treatment) described below, the present invention is not limited to the above-described upper limits.

It is preferable that the size d₃ of the gap G₃ is the same as the size d₂ of the second gap G₂ described above. By setting the size d₃ of the gap G₃ to 40 µm or less, which is the same as the size d₂ of the second gap G₂, the surface tension can be imparted to the raw material solution 36, and occurrence of vibration of the raw material solution 36 can be suppressed by the surface tension. Similar to the size d₃ of the gap G₃, in a case where film formation is carried out by fixing the coating blade 10, the lower limit of the size d₃ of the gap G₃ is 0 µm. In other words, the film formation may be carried out in a grounded state. In a case where film formation is carried out by moving the coating blade 10 or the substrate 30, the lower limit of the size d₃ of the gap G₃ is 10 µm.

Since the upper limit of the size d₃ of the gap G₃ is changed depending on the surface energy (the solvent, the material of the coating blade 10, and the surface treatment) described below, the present invention is not limited to the above-described upper limit.

The size d₃ of the gap G₃ is obtained by acquiring a digital image including the substrate 30 from the side surface of the coating blade 10, inputting this digital image into a computer, and measuring the length between the surface 30a of the substrate 30 and the bottom surface of the side surface 14 on the computer based on the digital image.

The coating blade 10 is disposed on the surface 30a of the substrate 30 in a state in which the first gap G₁, the second gap G₂, and the gap G₃ described above are maintained, and the liquid reservoir 34 can be allowed to be present in a space between the facing surface 12a and the side surfaces 14 of the coating blade 10 and the surface 30a of the substrate 30 depending on the amount of the raw material solution 36 to be supplied.

The liquid surface 36a of the raw material solution 36 is affected by the surface energy of the raw material solution 36, the surface energy of the facing surface 12a, and the surface energy of the side surfaces 14. Fig. 5 illustrates the liquid surface 36a of the raw material solution 36 in the open part 33 of the liquid reservoir 34. In the raw material solution 36, it is preferable that a film growth interface Bg is curved toward the center of the raw material solution 36.

The film growth interface Bg indicates a surface where drying of the solvent in the raw material solution 36 progresses during the formation of the film 38 (see Fig. 8). The drying of the solvent in the raw material solution 36 advances along the first direction D1 described below, and the liquid surface 36a is moved to a contact side 13 along the progression of the drying. Therefore, the film growth interface Bg is the liquid surface 36a.

Specifically, as illustrated in Fig. 5, it is preferable that the liquid surface 36a of the raw material solution 36 in the open part 33 is curved toward the center of the raw material solution 36. The curvature of the liquid surface 36a of the raw material solution 36 is caused by attraction of the raw material solution 36 to two side surfaces 14. In this case, the liquid surface 36a of the raw material solution 36 has a shape of a depression depressed to the contact side 13 in a plan view. In a case where the liquid surface 36a of the raw material solution 36 is curved, the vibration of the raw material solution 36 is suppressed so that a film having a small film thickness can be obtained.

Further, the liquid surface 36a of the raw material solution 36 may protrude toward the center of the raw material solution 36. In this case, the liquid surface 36a has a shape of a projection projected to the open part 33 side in a plan view. The center of the raw material solution 36 indicates the center of gravity of the raw material solution 36. In a case where the movement of the substrate 30 is accompanied, since the frictional force acts on the raw material solution 36 in a direction opposite to the first direction D1, the liquid surface 36a is likely to have a shape of a projection in a plan view.

By changing the solvent or the like, the surface energy of the raw material solution 36 can be changed. Further, the surface energy of the facing surface 12a and the surface energy of the side surfaces 14 can be changed by performing an ultraviolet (UV) treatment, a plasma treatment, and the like. The surface energy can be changed using the material. Since particularly the side surfaces 14 impart the surface tension to the raw material solution 36, it is preferable that the wettability with respect to the raw material solution 36 and particularly with respect to the solvent is high. In this manner, the liquid surface 36a of the raw material solution 36 can be formed in a shape of a depression or a projection.

Further, each side surface 14 is set to be perpendicular to the surface 30a of the substrate 30, but the present invention is not limited to the right angle. As illustrated in Fig. 6, the side surface 14 may be inclined with respect to the surface 30a of the substrate 30. The inclination of the side surface 14 is accepted to be 45° based on the right angle. In other words, the side surface 14 may be provided at 90° ± 45° with respect to the surface 30a of the substrate 30. It is more efficient that the side surface 14 is perpendicular to the surface 30a of the substrate 30 from the viewpoint of the crystal formation area.

The size d₃ of the gap G₃ described above and the size d₂ of the second gap G₂ described above are not necessarily the same as each other and may be different from each other.

Further, in a case where the substrate 30 is viewed from the upper side of the surface 30a, the side surfaces 14 are provided by extending in parallel with the first direction D1 as illustrated in Figs. 1 and 5. In other words, the side surfaces 14 are provided by extending perpendicularly to the second direction. However, the inclination of each side surface 14 in the first direction D1 is accepted to be 30° based on the state in which the side surface 14 is in parallel with the first direction D1. In other words, the side surface 14 may be provided at a disposition angle of 90° ± 30° with respect to the second direction D2. In consideration of the efficiency from the viewpoint of the crystal growth area, it is preferable that two side surfaces 14 are both provided at a disposition angle of 90°. Further, the disposition angles of two side surfaces 14 in a case where the substrate 30 is viewed from the upper side of the surface 30a may not be necessarily the same as each other. The disposition angles of two side surfaces 14 may be symmetric or left-right asymmetric.

The plane portion 12 and the side surfaces 14 of the coating blade 10 may be integrated or separated. The coating blade 10 is formed of glass, quartz glass, stainless steel, or the like.

As the substrate 30, for example, a glass substrate or a plastic substrate is used.

A plastic substrate is formed of, for example, polyesters such as polyethylene terephthalate (PET) and polyethylene naphthalate (PEN); polyolefins such as polyethylene (PE), polypropylene (PP), polystyrene, ethylene vinyl acetate (EVA), a cycloolefin polymer (COP), and a cycloolefin copolymer (COC); a vinyl-based resin; and polycarbonate (PC), polyamide, polyimide, an acrylic resin, or triacetylcellulose (TAC). The plastic substrate is not bent even at the time of being attempted to be bent and is used for formation according to a roll-to-roll system.

Next, a first example of a method of producing a film will be described.

Figs. 7 and 8 are schematic views sequentially illustrating steps in the formation step according to the first example of the method of producing a film of the embodiment of the present invention.

The coating blade 10 is disposed on the surface 30a of the substrate 30 toward the side surfaces 14. At this time, the coating blade 10 is provided such that the tilt angle θ, the first gap G₁, the second gap G₂, and the gap G₃ are set as described above. In this state, the raw material solution 36 is supplied, through the supply pipe 16, to a region surrounded by the surface 30a of the substrate 30, the facing surface 12a, and the side surfaces 14.

At this time, it is preferable that the substrate 30 is held at an appropriate temperature according to the type of the raw material solution 36. The substrate temperature of the substrate 30 can be adjusted using, for example, a hot plate. Further, it is preferable that the raw material solution 36 is heated to the same temperature as the substrate temperature before being supplied. It is preferable that the supply pipe 16 is also appropriately heated.

After the solvent of the raw material solution 36 is evaporated, the film 38 is formed on the surface 30a of the substrate 30 as illustrated in Fig. 8. In this case, the film 38 is formed by drying the solvent of the raw material solution 36 along a specific direction. The specific direction indicates the first direction D1 illustrated in Figs. 5 and 8. In this manner, the high-quality film 38 having high uniformity, in which the alignment is aligned, can be obtained.

The above-described specific direction indicates a direction in which drying of the solvent in the raw material solution 36 progresses, which is a direction in which the film 38 is formed. Further, the specific direction indicates a direction in which the film growth interface Bg, that is, the liquid surface 36a of the raw material solution 36 moves, and this specific direction is also referred to as a coating direction.

The above-described specific direction is determined by, for example, the facing surface 12a of the plane portion 12 of the coating blade 10. The facing surface 12a of the plane portion 12 is close to the surface 30a of the substrate 30 and the corner portion 12d (see Fig. 4). At the time of formation of the film 38, the solvent of the raw material solution 36 is dried from the open part 33 toward the contact side 13 including the corner portion 12d (see Fig. 4). In other words, the solvent is dried along the first direction D1, and thus the film 38 is formed along the first direction D1.

The surface tension is imparted to the raw material solution 36 by the side surfaces 14 as described above, but the side surfaces 14 do not affect the determination of the specific direction in the coating blade 10 illustrated in Fig. 1. In this case, the specific direction described above is determined only by the facing surface 12a of the plane portion 12 of the coating blade 10.

Further, the determination of the specific direction is also affected by the side surfaces 14 in some cases depending on the shape and the size of the coating blade 10, the surface energy of the raw material solution 36, and the surface energy of the side surface 14.

By providing the side surfaces 14, the surface tension can be imparted to the raw material solution 36 as described above.

Due to the evaporation of the solvent in the raw material solution 36, deposition and dissolution of the organic semiconductor, and the like, vibration of the raw material solution 36 occurs. Since the vibration of the raw material solution 36 is suppressed by the surface tension of the side surfaces 14 described above, continuous crystals can be prepared in a stabilized manner. Since the surface tension is imparted, it is preferable that the side surfaces 14 have high wettability with respect to the raw material solution 36 and particularly with respect to the solvent.

In a case where the side surfaces 14 are provided, nucleation of the organic semiconductor or the like is suppressed because evaporation of the raw material solution 36 and deposition and dissolution of the organic semiconductor do not occur inside the side surfaces 14. Accordingly, the uniformity of the film quality in the film 38 can be increased. The uniformity of the film 38 indicates that unevenness in film thickness is small and a continuous crystal film is formed. In addition to this, the uniformity also indicates that the state of the film 38 is uniform, for example, the alignment direction is aligned over the entire film in a case of an alignment film and the crystal orientation is aligned over the entire film in a case of crystal orientation.

Due to the capillary phenomenon, since the raw material solution 36 goes around the outside of the side surfaces 14 through a space between the side surfaces 14 and the substrate 30 or the outer periphery of the side surfaces 14, evaporation of the raw material solution 36 and deposition and dissolution of the organic semiconductor or the like occur outside the side surfaces 14.

However, the side surfaces 14 are present between a site where the raw material solution 36 is evaporated and the liquid reservoir 34 of the raw material solution 36. Therefore, practically, the vibration is unlikely to be transmitted to the raw material solution 36 inside the side surfaces 14. As the result, the vibration of the raw material solution 36 is suppressed.

The evaporation of the solvent in the raw material solution 36 is suppressed by providing the side surfaces 14. However, due to the presence of the side surfaces 14, the evaporation speed of the solvent is practically increased. This is because the raw material solution 36 also goes around the outside of the side surfaces 14 and then is evaporated due to the capillary phenomenon. An increase in evaporation speed leads to a reduction in film thickness of the film 38 of the organic semiconductor film or the like to be formed. As the result, the film 38 with a small film thickness can be obtained so that the thickness of the film 38 can be reduced.

Further, the configuration in which two side surfaces 14 are provided has been described, but the configuration is not limited thereto as long as at least one side surface 14 is provided. In a case where at least one side surface 14 is present, the high-quality film 38 having a small film thickness and high uniformity in film thickness or the like can be obtained.

Moreover, as a coating method for obtaining a high-quality crystal film, a method of using a coating blade inclined with respect to the surface 30a of the substrate 30 (hereinafter, also referred to as a "wedge method") has been suggested. According to the wedge method, the vibration of the raw material solution is suppressed by the surface tension while the substrate temperature is increased so that discontinuity such as step-cut of crystals is suppressed. The present invention is different from other techniques in terms that the surface tension can be further imparted to the raw material solution 36 by further providing side surfaces on the coating blade.

According to a film forming method referred to as an edge cast method, the organic semiconductor is deposited on the outer periphery of a wall, but is different from the film such as an organic semiconductor film or the like described in the present invention.

The edge cast method is a coating method of performing crystal growth toward glass which is an edge, but the crystal growth method for an organic semiconductor film described in the present invention is basically not a coating method of performing crystal growth toward the side surface. In the configuration of the side surface 14 illustrated in Fig. 1, the crystal growth occurs perpendicular to the side surface 14 and the crystal growth is not performed toward the side surface 14.

Here, in regard to the substrate 30, in a case where the substrate 30 is present alone or a layer (not illustrated) is formed on the surface 30a of the substrate 30 and the film 38 (see Fig. 8) formed of an organic semiconductor material, a crystal material, or an alignment material is formed on the surface of the layer (not illustrated), the surface of the layer corresponds to the surface 30a of the substrate 30.

Next, an example of a thin film transistor to be produced according to the method of producing a film will be described.

Fig. 9 is a schematic cross-sectional view illustrating an example of a thin film transistor to be produced using the method of producing a film according to the embodiment of the present invention.

The thin film transistor 40 illustrated in Fig. 9 is a bottom-gate top-contact type transistor. The thin film transistor 40 is provided such that a gate electrode 43 is formed on a surface 42a of a substrate 42. An insulating film 44 that covers this gate electrode 43 is formed on the surface 42a of the substrate 42. An organic semiconductor layer 46 is formed on a surface 44a of an insulating film 44. This organic semiconductor layer 46 is produced according to the method of producing a film. A source electrode 48a and a drain electrode 48b are formed on a surface 46a of the organic semiconductor layer 46.

Further, in the thin film transistor 40, the organic semiconductor layer 46 is formed on the surface 44a of the insulating film 44. In this case, the surface 44a of the insulating film 44 corresponds to the surface 30a of the substrate 30 as described above.

Here, in order to make a low-molecular organic semiconductor obtain high performance such as a high mobility, it is necessary to obtain an aligned continuous crystal film and to maintain the film thickness of the organic semiconductor layer to be small.

There is a direction in which electricity easily flows in an organic semiconductor and discontinuity of crystals becomes a resistance due to the aligned continuous crystal film described above.

The maintenance of the film thickness of a crystal film to be small is a request in a case of a bottom-gate top-contact type transistor. Since the current path of a thin film transistor is in the vicinity of the interface between the insulating film and the organic semiconductor layer, the thickness of the organic semiconductor layer becomes a resistance component. Typically, it is desired that the thickness of the organic semiconductor layer is several tens of nanometers (several layers). However, as the thickness thereof is decreased, it becomes difficult to carry out film formation through coating.

By employing the method of producing a film described above, the organic semiconductor layer 46 which is an aligned continuous crystal film and has a small film thickness can be obtained. Therefore, a thin film transistor having high performance such as a high mobility can be obtained.

Further, a transistor on which the organic semiconductor film is formed according to the method of producing a film is not limited to the bottom-gate top-contact thin film transistor 40 illustrated in Fig. 9. The transistor may be a bottom-gate bottom-contact type thin film transistor, a top-gate top-contact type thin film transistor, or a top-gate bottom-contact type thin film transistor.

In addition to the production of the thin film transistor 40 described above, the method of producing a film can be used for producing various films, for example, a photoelectric conversion film and a photoelectric modulation film such as an organic solar cell, an electrooptic conversion film and an electrooptic modulation film such as an organic EL, a memory such as an organic ferroelectric memory, an organic conductive film, an inorganic conductive film, a polarizing film, an optical retardation film, a light guide, an optical amplification film, a gas sensor such as a volatile organic compound (VOC) sensor, a self-assembled film such as a block copolymer, a molecular alignment film, and a nanoparticle alignment film.

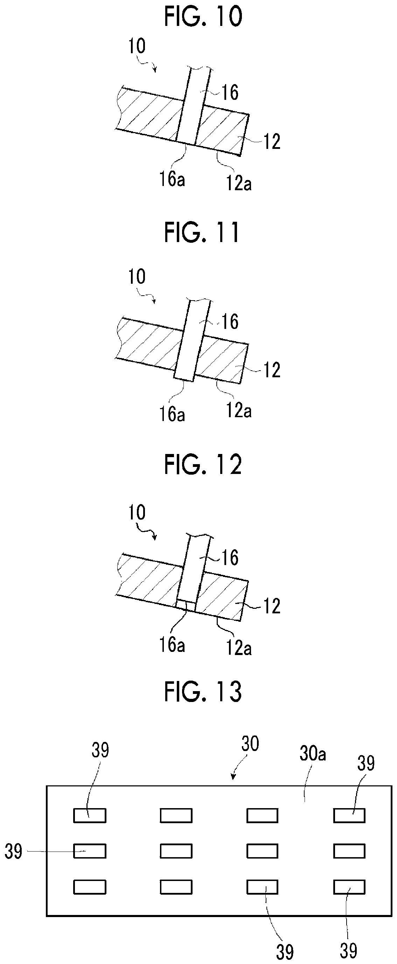

Fig. 10 is a schematic cross-sectional view illustrating the first example of a position where a supply port of a supply pipe in the coating blade used for the method of producing a film according to the embodiment of the present invention is disposed. Fig. 11 is a schematic cross-sectional view illustrating a second example of a position where a supply port of a supply pipe in a coating blade is disposed. Fig. 12 is a schematic cross-sectional view illustrating a third example of a position where a supply port of a supply pipe in a coating blade is disposed.

In the coating blade 10, a supply port 16a of a supply pipe 16 in the plane portion 12 is flush with the facing surface 12a of the plane portion 12 illustrated in Fig. 10, but the present invention is not limited to this configuration. The supply port 16a of the supply pipe 16 may protrude from the facing surface 12a of the plane portion 12 as illustrated in Fig. 11 or the supply port 16a of the supply pipe 16 may be depressed from the facing surface 12a of the plane portion 12 as illustrated in Fig. 12 and may be present inside the plane portion 12. The supply port 16a is used to supply the raw material solution 36.

Further, the position where the supply port 16a of the supply pipe 16 is disposed is not particularly limited. For example, it is preferable that the supply port 16a thereof is disposed in two central sections from among four equal intervals obtained by dividing the length of the first direction D1 in which the liquid reservoir 34 as a region where the coating blade 10 is in contact with the above-described various raw material solutions 36 is projected on the surface 30a of the substrate 30. Further, the region where the above-described liquid reservoir 34 is projected is a region from the above-described vertical straight line La to the corner portion 12d of the plane portion 12 in the coating blade 10 illustrated in Figs. 2 to 4.

Next, the second example of the method of producing a film will be described.

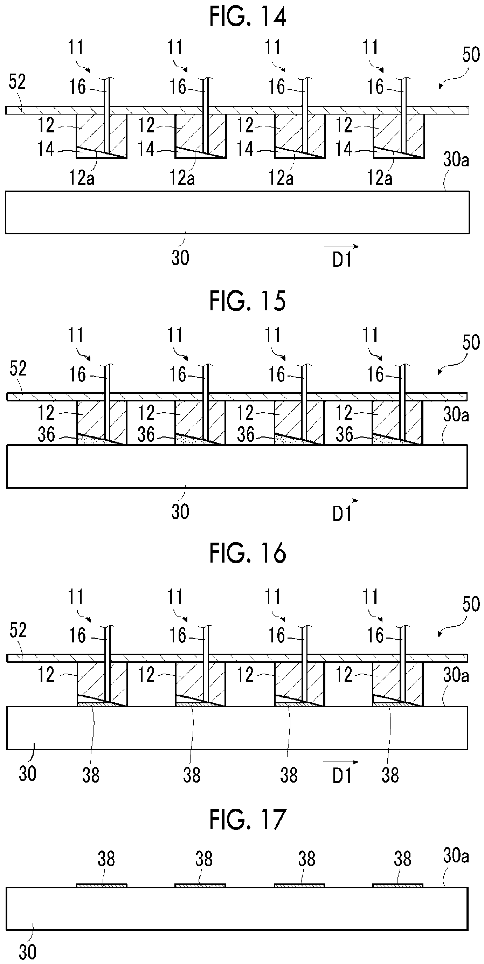

Fig. 13 is a schematic view illustrating an example of disposition of a film to be formed according to the method of producing a film according to the embodiment of the present invention. Figs. 14 to 17 are schematic views sequentially illustrating steps in the second example of the method of producing a film according to the embodiment of the present invention. In Figs. 13 to 17, the same constituent elements as those in the coating blade 10 and the substrate 30 illustrated in Figs. 1 to 6 are denoted by the same reference numerals and the detailed description thereof will not be provided. In Figs. 14 to 16, the tilt angle θ, the first gap G₁, the second gap G₂, and the gap G₃ are not illustrated, but the tilt angle θ, the first gap G₁, the second gap G₂, and the gap G₃ are the same as those in the coating blade 10 illustrated in Fig. 1.

According to the method of producing a film, the film 38 can be formed in each of a plurality of regions 39 on the surface 30a of one substrate 30 illustrated in Fig. 13. Each region 39 is a region where the film 38 is formed, and the regions are separated from one another and regularly arranged. For example, the shapes and the areas of the regions 39 are the same.

The film 38 to be formed in a plurality of regions 39 corresponds to, for example, the organic semiconductor layer 46 of the thin film transistor 40. In a case where the thin film transistor 40 is prepared, the plurality of regions 39 are regularly arranged, but the arrangement of the plurality of regions 39 is appropriately determined depending on the target to be prepared and is not particularly limited to the regular arrangement.

In a case where a plurality of films 38 are formed on one substrate 30, a coating head 50 including a plurality of coating blades 11 is used as illustrated in Fig. 14.

In the coating head 50, the plurality of coating blades 11 are arranged in a support 52 in the same manner as the arrangement of the regions 39 illustrated in Fig. 13.

The coating blade 11 is different from the coating blade 10 illustrated in Fig. 1 in terms of the configuration of the plane portion 12, but other configurations are the same as the configurations of the coating blade 10 illustrated in Fig. 1. In the coating blade 11, the plane portion 12 does not have a shape of a flat plate and is formed of a block-like member having the facing surface 12a. The plane portion 12 is attached to the support 52 in accordance with the positions of the regions 39. In addition, the supply pipe 16 is provided in each coating blade 11.

The coating head 50 includes an elevating unit (not illustrated) which elevates and lowers the coating head 50; and a supply unit (not illustrated) which supplies the raw material solution 36 to the coating blade 11. Further, a heating unit (not illustrated) such as a hot plate which heats the substrate 30 and holds the increased temperature is also provided.

Further, the conditions for the substrate temperature and the like during the formation of the film 38 are the same as the conditions in the first example of the method of producing the film 38 illustrated in Figs. 7 and 8.

As illustrated in Fig. 14, the coating head 50 is disposed such that the facing surfaces 12a are directed toward the surface 30a of the substrate 30.

Next, the coating blades 11 are provided on the surface 30a of the substrate 30 using an elevating unit (not illustrated) by bringing the coating head 50 closer to the surface 30a such that the tilt angle θ, the first gap G₁, the second gap G₂, and the gap G₃ are set to be the same as described above as illustrated in Fig. 15. In this state, the raw material solution 36 is supplied from the supply pipe 16 to a space between the facing surface 12a and the surface 30a of the substrate 30.

The substrate 30 is heated, and the temperature thereof is maintained to a specific substrate temperature. The solvent in the raw material solution 36 is dried along a specific direction as described above, for example, along the first direction D1. In this manner, the film 38 is formed as illustrated in Fig. 16.

Next, after the raw material solution 36 is dried, the coating head 50 is allowed to be spaced from the surface 30a of the substrate 30 using the elevating unit (not illustrated). As illustrated in Fig. 17, a plurality of films 38 are formed on the surface 30a of the substrate 30.

Next, the third example of the method of producing a film will be described.

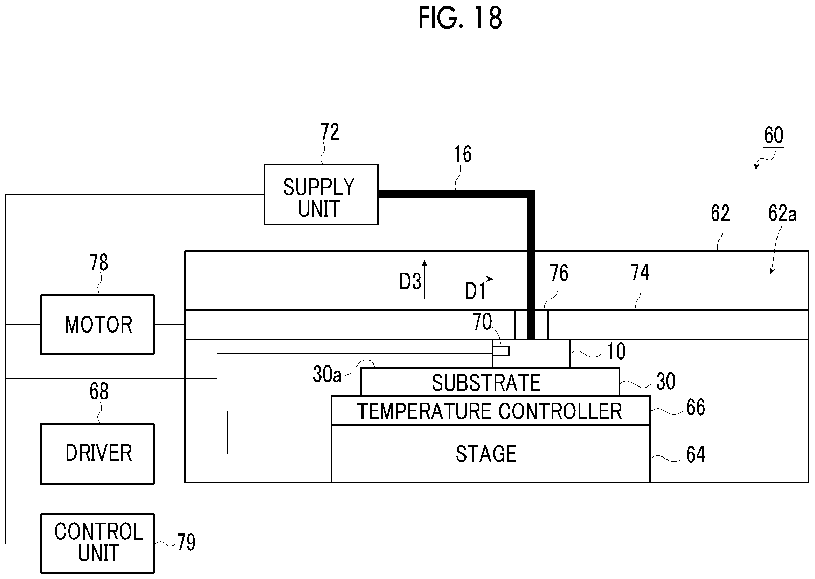

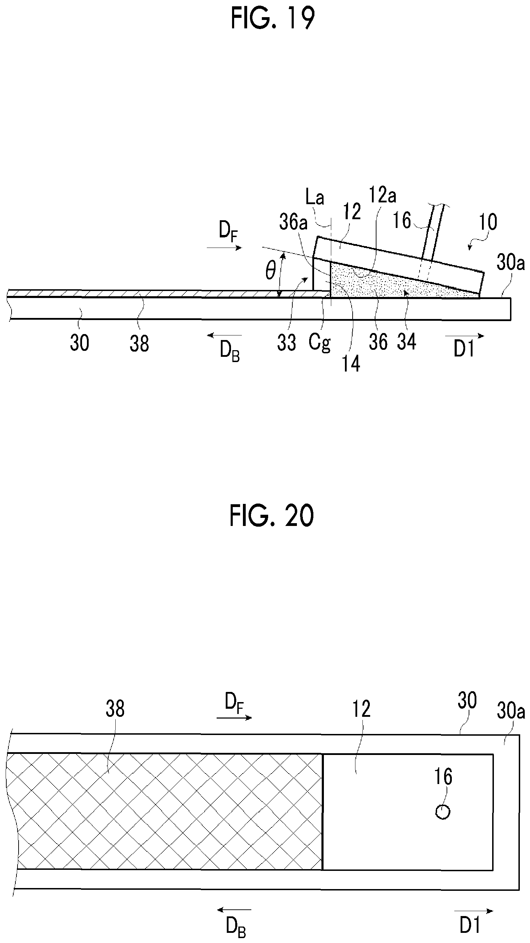

Fig. 18 is a schematic view illustrating the first example of a production device used for the method of producing a film according to the embodiment of the present invention. Fig. 19 is a schematic view for describing the third example of the method of producing a film according to the embodiment of the present invention. Fig. 20 is a plan view for describing the third example of the method of producing a film according to the embodiment of the present invention.

A production device 60 illustrated in Fig. 18 is provided with a stage 64 in an inner portion 62a of a casing 62; a temperature controller 66 disposed on the stage 64; the coating blade 10; and a guide rail 74 which moves the coating blade 10 in the first direction D1 and the direction opposite to the first direction D1. The first direction D1 indicates the longitudinal direction of the plane portion 12 as described above.

The stage 64 and the temperature controller 66 are connected to a driver 68, and movement of the substrate 30 by the stage 64 and control of the temperature of the substrate 30 by the temperature controller 66 are performed by the driver 68. The coating blade 10 is connected to a supply unit 72 through the supply pipe 16.

The guide rail 74 is connected to a motor 78, and the motor 78 allows the coating blade 10 to move in the first direction D1 and the direction opposite to the first direction D1.

The driver 68, the supply unit 72, and the motor 78 are connected to a control unit 79, and the driver 68, the supply unit 72, and the motor 78 are controlled by the control unit 79.

The first direction D1 is aligned in a direction parallel to the surface of the stage 64. Accordingly, the direction opposite to the first direction D1 is also a direction parallel to the surface of the stage 64. Further, since the substrate 30 is disposed on the stage 64 such that the surface 30a of the substrate 30 is in parallel with the surface of the stage 64, the first direction D1 is a direction defined as a surface (not illustrated) parallel to the surface 30a of the substrate 30.

The stage 64 is a place where the temperature controller 66 is disposed and the substrate 30 is further disposed thereon and is capable of moving the substrate 30 in the first direction D1 and the direction opposite to the first direction D1. Further, the stage 64 is capable of moving the substrate 30 in a second direction D2 (see Fig. 1) orthogonal to the first direction D1 and in a direction opposite to the second direction D2.

The configuration of the stage 64 is not particularly limited as long as the substrate 30 can be moved in the first direction D1 and the direction opposite thereto, and the second direction D2 and the direction opposite thereto. The stage 64 may have a configuration of allowing the substrate 30 to move in a third direction D3 orthogonal to the first direction D1 and the second direction D2.

The temperature controller 66 adjusts the temperature of the substrate 30 to a predetermined temperature and holds the temperature. The configuration of the temperature controller 66 is not particularly limited as long as the temperature of the substrate 30 can be set to a predetermined temperature as described above. As the temperature controller 66, for example, a hot plate can be used.

The configuration of the supply pipe 16 connected to the coating blade 10 is not particularly limited as long as various solutions for forming a film described above can be supplied to a space between the facing surface 12a (see Fig. 2) of the coating blade 10 and the surface 30a of the substrate 30 from the supply unit 72. It is preferable that the supply pipe 16 has a flexibility so as to follow the coating blade 10 during the movement of the coating blade 10. The number of the supply pipes 16 is not limited to one, and a plurality of supply pipes 16 may be provided. The number thereof is appropriately determined depending on the size of the coating blade 10, the size of a film to be formed, and the like.

The supply unit 72 is used to supply the raw material solution 36 to a space between the facing surface 12a (see Fig. 2) of the coating blade 10 and the surface 30a of the substrate 30 as described above and includes a tank (not illustrated) which stores the raw material solution 36; a pump (not illustrated) which sends the raw material solution 36 in the tank to the coating blade 10; and a flow meter (not illustrated) which measures the amount of the raw material solution 36 to be sent described above. As the supply unit 72, for example, a syringe pump can be used.

It is desired that the supply unit 72 and the supply pipe 16 are heated so that the temperature thereof is adjusted at an appropriate time. The temperature thereof is desirably set to approximately the same temperature as the substrate temperature. The raw material solution 36 can be stably supplied by reliably dissolving the raw material solution 36 for forming a film through the heating. Further, as a difference in temperature between the raw material solution 36 and the substrate 30 at the time of being supplied is decreased, the stabilized liquid reservoir 34 (see Fig. 2) can be formed.

Further, the coating blade 10 is provided with a sensor 70 which measures the distance between the surface 30a of the substrate 30 to be disposed on the temperature controller 66 and the facing surface 12a (see Fig. 2) of the coating blade 10 (see Fig. 2). The sensor 70 is connected to the control unit 79 so that the driver 68, the supply unit 72, and the motor 78 are controlled by the control unit 79 based on the distance between the surface 30a of the substrate 30 and the facing surface 12a (see Fig. 2) of the coating blade 10 (see Fig. 2). The configuration of the sensor 70 is not particularly limited as long as the above-described distance can be measured, and the distance thereof is measured using, for example, an optical measuring method. As the sensor 70, a sensor using light interference, a sensor using the confocus, or a sensor using laser light can be appropriately used.

In the coating blade 10, a carriage 76 is attached to the guide rail 74. The carriage 76 can be moved in the first direction D1 and the direction opposite to the first direction D1 by the guide rail 74, and the coating blade 10 is moved in the first direction D1 and the direction opposite to the first direction D1 together with the carriage 76. The carriage 76 is moved in the first direction D1 and the direction opposite to the first direction D1 by the motor 78.

The position of the carriage 76 can be calculated based on read values of a linear scale (not illustrated) provided on the guide rail 74, and thus the position of the coating blade 10 in the first direction D1 can be calculated. The carriage 76 is capable of changing the height at which the coating blade 10 has been attached and the tilt angle θ. In addition, the moving speed of the facing surface 12a (see Fig. 2) of the coating blade 10 is adjusted by the motor 78.

In the production device 60, the coating blade 10 can be moved in the first direction D1 and the direction opposite to the first direction D1, and the substrate 30 can be moved in the first direction D1 and the direction opposite to the first direction D1.

In regard to the size d₁ of the first gap G₁ and the size d₂ of the second gap G₂, in the production device 60, the size d₂ of the second gap G₂ is measured based on the amount of the carriage 76 to be elevated in a state in which the facing surface 12a of the coating blade 10 is brought into contact with the surface 30a of the substrate 30. The size d₂ of the second gap G₂ can be measured in a case where a micrometer (not illustrated) for adjusting the height is provided in the carriage 76. Further, the size d₁ of the first gap G₁ can be calculated based on the length of the coating blade 10 in a case where the tilt angle θ of the coating blade 10 is known. In Fig. 1, the length of the coating blade 10 is the length of the plane portion 12 in the longitudinal direction.

Next, a method of continuously forming a film will be described.

The facing surface 12a of the coating blade 10 is disposed on the surface 30a of the substrate 30 such that the facing surface 12a is inclined at a tilt angle θ in a state in which the first gap G₁, the second gap G₂, and the gap G₃ described above are provided.

Next, the raw material solution 36 is supplied to the liquid reservoir 34 through the supply pipe 16 from the supply unit 72 (see Fig. 18). At this time, the substrate temperature of the substrate 30 is set to a predetermined temperature using the above-described temperature controller 66 (see Fig. 18).

The substrate 30 is moved in a direction D_{B} from the coating blade 10 at a predetermined moving speed in a state in which the facing surface 12a of the coating blade 10 is in contact with the raw material solution 36 as illustrated in Figs. 19 and 20 while the raw material solution 36 is supplied to a space between the coating blade 10 and the surface 30a of the substrate 30, that is, the liquid reservoir 34. In this manner, the region where the liquid surface 36a of the raw material solution 36 of the open part 33 is in contact with the surface 30a of the substrate 30 becomes a crystal growth portion Cg (see Fig. 19) serving as a starting point where the film 38 is formed, and the film 38 is sequentially formed from this crystal growth portion Cg in a direction D_{F}. Therefore, the film 38 is continuously formed in the direction D_{F} while the raw material solution 36 is applied to the direction D_{F} in which the coating blade 10 is moved.

Even in a case where the film 38 is continuously formed while the raw material solution 36 is supplied, since the surface tension is imparted to the raw material solution 36, the vibration of the raw material solution 36 is suppressed, and the evaporation speed of the raw material solution 36 is increased by providing the side surfaces 14, a film having a uniform film thickness can be continuously formed. Therefore, this contributes to raising the speed of film formation.

Further, the direction D_{B} is a direction toward the open part 33 from the center of the raw material solution 36, which is the same direction as the direction opposite to the first direction D1 described above. The direction D_{F} is a direction opposite to the direction D_{B}, which is the same direction as the first direction D1.

In a case where the film formation is carried out by moving the substrate 30, the lower limit of the size d₂ of the second gap G₂ is 10 µm as described above, and the lower limit of the size d₃ of the gap G₃ is 10 µm. Since the film formation is carried out while the raw material solution 36 is supplied, the film formation can be made in a state in which the size d₁ of the first gap G₁ is not changed. In addition, the size d₁ of the first gap G₁ may be changed. Even in a case where a film is continuously formed, the size d₂ of the second gap G₂ and the size d₃ of the gap G₃ may be the same as or different from each other.

The amount of the raw material solution 36 to be supplied is appropriately determined according to the temperature and the moving speed of the substrate 30, the size of the film 38 to be formed, and the like.

In regard to the crystal growth portion Cg, the crystal growth portion Cg can be specified by acquiring a digital image including the liquid reservoir 34 and the film 38, inputting this digital image into a computer, and visually observing the vicinity of the boundary between the liquid reservoir 34 and the film 38 based on this digital image.

Further, the method of continuously forming the film 38 by moving the substrate 30 in the direction D_{B} has been described, but the present invention is not limited thereto. In addition, the film 38 can be continuously formed in the direction D_{F} as described above by moving the coating blade 10 in the direction D_{F} at a predetermined moving speed.

In a case where the boiling point of the solvent in the raw material solution 36 is set as Tb°C and the substrate temperature is set as Ts°C, it is preferable that the substrate temperature Ts is held to a temperature satisfying an expression "Tb - 50°C ≤ Ts ≤ Tb" according to any method of producing the film 38 described above. In a case where the substrate temperature is in the above-described temperature range, evaporation of the solvent in the raw material solution 36 is promoted, and the film formation speed for the film 38 can be increased. Therefore, the productivity of the film 38 can be increased.

It is more preferable that the substrate temperature Ts during the formation of the film 38 satisfies an expression "Tb - 20°C ≤ Ts ≤ Tb". Further, the substrate temperature Ts indicates the temperature of the surface 30a of the substrate 30.

The moving speed of the substrate 30 during the formation of the film 38, that is, the moving speed of the facing surface 12a of the coating blade 10 is preferably 5 mm/min or greater and more preferably 10 mm/min or greater. In a case where the moving speed described above is 5 mm/min or greater, the film 38 can be formed at a high film formation speed and the productivity can be increased. Further, the upper limit of the moving speed described above is approximately 100 mm/min, and an organic semiconductor film with excellent crystallinity as the film 38 and a high mobility can be obtained in a case where the above-described moving speed is 100 mm/min or less.

Further, the film 38 is formed, for example, in an atmosphere under atmospheric pressure.

According to the method of producing the film 38, the distance between the facing surface 12a of the coating blade 10 and the surface 30a of the substrate 30 is measured by the sensor 70 (see Fig. 18), the first gap G₁, the second gap G₂, and the gap G₃ are maintained, and the substrate 30 is moved in the direction D_{B}.

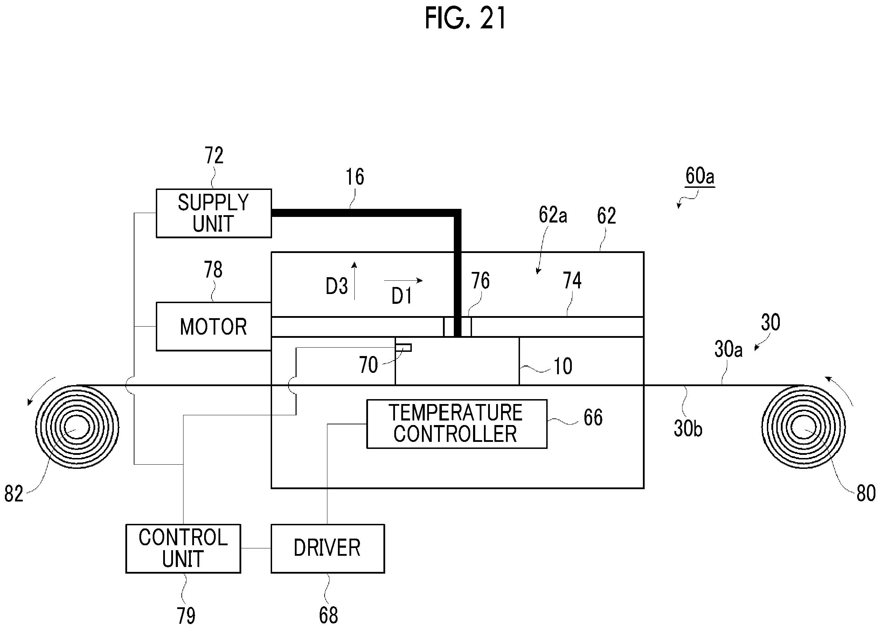

The production device 60 is of a single wafer type, but the method of producing a film is not limited to the single wafer type, and a roll-to-roll type production device as a production device 60a illustrated in Fig. 21 may be employed.

Further, in the production device 60a in Fig. 21, the same constituent elements as those in the production device 60 illustrated in Fig. 18 are denoted by the same reference numerals and the detailed description thereof will not be provided.

The production device 60a illustrated in Fig. 21 is different from the production device 60 illustrated in Fig. 18 in terms that the stage 64 is not provided, the transport form of the substrate 30 is stretched to an unwinding roll 80 and a winding roll 82, the coating blade 10 is disposed on the surface 30a side of the substrate 30 as described above, and the temperature controller 66 is disposed on a rear surface 30b side. The configurations other than these are the same as the configurations of the production device 60 illustrated in Fig. 18.

In the production device 60a in Fig. 21, the substrate temperature is set to a predetermined temperature by the temperature controller 66 so that the film 38 is formed by the coating blade 10. Further, during the film formation of the film 38, the substrate 30 may be transported by being wound up using the winding roll 82, and the coating blade 10 may be moved.

The above-described raw material solution 36 for forming a film is, for example, a solution containing a material having an aligning property. The solution containing a material having an aligning property is, for example, a solution containing a material that forms a crystal or a solution containing an organic semiconductor. The organic semiconductor may be not only a transistor but also an organic solar cell material. Examples of the material having a crystallinity include an organic ferroelectric material such as croconic acid or an imidazole compound; and a gas sensor material such as a pyrrole imine-naphthalene diimide (PI-NDI) compound.

Hereinafter, the solution containing an organic semiconductor used for the raw material solution 36 will be described in detail. The solution containing an organic semiconductor typically contains at least an organic semiconductor (organic semiconductor compound) and a solvent.

The type of the organic semiconductor is not particularly limited, and a known organic semiconductor can be used. Specific examples thereof include pentacenes such as 6,13-bis(triisopropylsilylethynyl)pentacene (TIPS pentacene), tetramethyl pentacene, and perfluoropentacene; anthradithiophenes such as TES-ADT (5,11-bis(triethylsilylethynyl)anthradithiophene), and diF-TES-ADT (2,8-difluoro-5,11-bis(triethylsilylethynyl)anthradithiophene); benzothienobenzothiophenes such as DPh-BTBT (2,7-dipheny1[1]benzothieno[3,2-b][1]benzothiophene) and Cn-BTBT (benzothienobenzothiophene); dinaphthothienothiophenes such as C10-DNBDT (3,11-didecyl-dinaphtho[2,3-d:2',3'-d']-benzo[1,2-b:4,5-b']dithiophene) and Cn-DNTT (dinaphtho[2,3-b:2',3'-f]thieno[3,2-b]thiophene); dioxaanthanthrenes such as perixanthenoxanthene; rubrenes; fullerenes such as C60 and PCBM([6,6]-phenyl-C61-butyric acid methyl ester); phthalocyanines such as copper phthalocyanine and fluorinated copper phthalocyanine; polythiophenes such as P3RT (poly(3-alkylthiophene)), PQT (poly[5,5'-bis(3-dodecyl-2-thienyl 1)-2,2'-bithiophene]), and P3HT (poly(3-hexylthiophene)); and polythienothiophenes such as poly[2,5-bis(3-dodecylthiophene-2-yl)thieno[3,2-b]thiophene] (PBTTT).

Further, the type of the solvent is not particularly limited, and examples thereof include alcohol-based solvents such as methanol and ethanol; ketone-based solvents such as acetone, methyl ethyl ketone, and methyl isobutyl ketone; aromatic solvents such as benzene and thiophene, and halogen (chlorine, bromine, or the like) substituted substances (halogenated aromatic solvents) thereof; ether-based solvents such as tetrahydrofuran and diethyl ether; amide-based solvents such as dimethylformamide and dimethylacetamide; and sulfonic acid-based solvents such as dimethyl sulfoxide and sulfolane.

The present invention is basically configured as described above. Hereinbefore, the method of producing a film according to the embodiment of the present invention has been described in detail, but the present invention is not limited to the above-described embodiments, and various improvements and modifications can also be made within the range not departing from the scope of the present invention.

### Examples

The features of the present invention will be described in more detail with reference to the following examples. The materials, the reagents, the use amounts, the amounts of materials, the proportions, the treatment contents, the treatment procedures, and the like described in the following examples can be appropriately changed within the range not departing from the scope of the present invention. Accordingly, the range of the present invention should not be limitatively interpreted by the specific examples described below.

In the present examples, organic semiconductor layers respectively formed of an organic semiconductor film were formed according to the method of producing a film, thereby obtaining thin film transistors of Examples 1 to 20 and Comparative Example 1. With respect to the thin film transistors in Example 1, Example 2, and Comparative Example 1, the film thicknesses and the thin film transistor element characteristics were evaluated. With respect to the thin film transistors in Examples 3 to 20, the thin film transistor element characteristics were evaluated.

Each thin film transistor was prepared in the following manner by setting the channel width to 1 mm and the channel length to 50 µm using the bottom-gate top-contact type thin film transistor 40 illustrated in Fig. 9.

### <Substrate and lower electrode>

First, after a glass substrate was washed, a gate pattern was prepared through vacuum deposition using a metal mask. Chromium (Cr) having a thickness of 10 nm was deposited as an adhesive layer to form a gate electrode having a thickness of 40 nm using silver (Ag).

Next, a polyimide insulating film having a thickness of 0.5 µm was formed by spin-coating the glass substrate and curing the resultant.

### <Coating of organic semiconductor>

Next, the glass substrate was provided on a hot plate present on a stage, the temperature of the surface of the substrate was set to 100°C, 120°C, or 140°C, and the surface thereof was coated with the raw material solution described below to form an organic semiconductor film, thereby obtaining an organic semiconductor layer.

Slide glass was used as the coating blade. The height of the slide glass with respect to the surface of the glass substrate was adjusted such that the tilt angle was set to be in a range of 1° to 6°.

Slide glass having a width of 18 mm, 24 mm, or 32 mm was used.

The raw material solution whose concentration was adjusted to be in a range of 0.05% to 0.3% by mass was supplied to a space below the coating blade such that the length was set to be in a range of 10 to 20 mm. After the raw material solution was supplied, a glass material having a rectangular parallelepiped shape was provided as the side surface. A glass material having a size of 20 mm × 5 mm × 2 mm was used as the glass material.

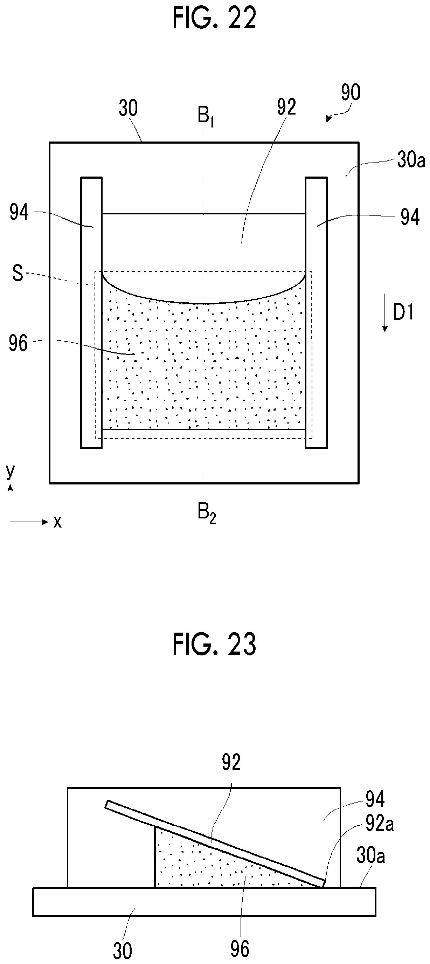

The amount of the raw material solution was reduced due to evaporation toward the coating blade and a contact side 92a (see Fig. 23) of the substrate in a state in which the coating blade was allowed to stand on the glass substrate and the position thereof was fixed so that an organic semiconductor film was formed.

In the raw material solution, anisole was used as the solvent using C4-TBBT (thieno[3,2-f:4,5-f']bis[1]benzothiophene) as the organic semiconductor. The raw material solution was obtained by heating and dissolving anisole such that the concentration of the above-described organic semiconductor was set to 0.1% by mass.

### <Formation of electrode>

Next, a gold (Au) film having a thickness of 70 nm was formed on the organic semiconductor layer as a source drain electrode according to a vacuum deposition method performed using a metal mask. The position of the electrode was adjusted such that a thin film transistor was prepared in the vicinity of the center of the organic semiconductor with respect to the coating width thereof.

### [Example 1, Example 2, and Comparative Example 1]

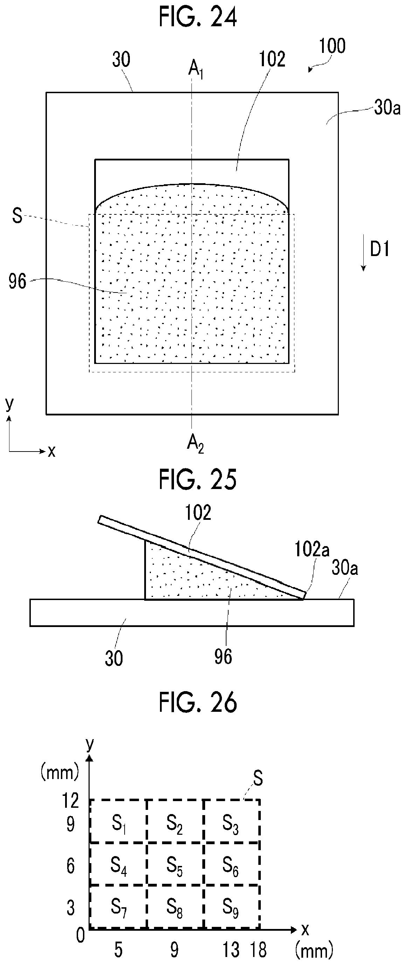

The coating blade was provided at a tilt angle of 4° using slide glass having a width of 18 mm. The substrate temperature was set to 120°C. The solution concentration of the raw material solution was examined while being adjusted such that a high-quality film having a concentration of 0.05% to 0.3% by mass was able to be obtained. The raw material solution was introduced up to the extent that the solution length was 12 mm. The value of the solution length is a value of the y axis in Fig. 26.

The numerical value of the solution length was set to a value of the length in a Y direction parallel to the first direction D1.The width was set to a value of the length in an X direction orthogonal to the Y direction.

Example 1 has a configuration illustrated in Figs. 22 and 23, and a coating blade 90 was configured to include a plane portion 92 and side surfaces 94. A reference numeral 92a in Fig. 23 represents a contact side. Further, Fig. 23 is a cross-sectional view taken along a line B₁-B₂ of Fig. 22.

In Example 2, an ultraviolet (UV) treatment was performed on the glass material of the side surface of the coating blade.

Comparative Example 1 has a configuration illustrated in Figs. 24 and 25, and a coating blade 100 was configured to have only a plane portion 102 and was not provided with a glass material on the side surface thereof. A reference numeral 102a in Fig. 25 represents a contact side. Further, Fig. 25 is a cross-sectional view taken along a line A₁-A₂ of Fig. 24.

### [Examples 3 to 20]

The coating blade was provided at a tilt angle of 1° to 6° using slide glass having a width of 18 mm. The substrate temperature was set to 100°C, 120°C, or 140°C. The solution concentration of the raw material solution was examined while being adjusted such that a high-quality film having a concentration of 0.05% to 0.3% by mass was able to be obtained. The raw material solution was introduced up to the extent that the solution length was 12 mm. The value of the solution length is a value of the y axis in Fig. 26.

In order to evaluate the thin film transistor element characteristics, the saturation mobility of each of nine regions S₁ to S₉ illustrated in Fig. 26 was measured in the same manner as in Example 1, Example 2, and Comparative Example 1, the measured values were averaged, and the thin film transistor element characteristics were evaluated based on the average value, as described below.

The film thicknesses and the thin film transistor element characteristics of Example 1, Example 2, and Comparative Example 1 are listed in Table 1 below. The thin film transistor element characteristics of Examples 3 to 20 are listed in Table 2 below.

Further, in Tables 1 and 2 below, the thin film transistor element characteristics are noted as "TFT characteristics".

Hereinafter, the methods of measuring the film thickness of the organic semiconductor film and the saturation mobility of the organic semiconductor film will be described.

### <Film thickness>

The film thickness of the formed organic semiconductor film was obtained by dividing the region S illustrated in Fig. 26 into a total of nine regions S₁ to S₉, and measuring the film thickness of each of the regions S₁ to S₉. A stylus type step profiler (DEKTAK) was used for measuring the film thickness of the organic semiconductor film. In the coating blade used in the example illustrated in Fig. 22 and the coating blade used in the comparative example illustrated in Fig. 24, the region S was set to have the same range. The range of the region S illustrated in Figs. 22 and 24 was set to have a size of 12 mm in the y direction and a size of 18 mm in the x direction.

### <Saturation mobility>

In regard to the thin film transistor element characteristics, the saturation mobility of each of the prepared thin film transistors was measured using a semiconductor parameter analyzer (manufactured by Agilent Technologies, Inc., 4156C)
The saturation mobility was obtained by dividing the region S illustrated in Fig. 26 into a total of nine regions S₁ to S₉ similar to the measurement of the film thickness and measuring the saturation mobility of each of the regions S₁ to S₉.

The thin film transistor element characteristics were evaluated based on the measured saturation mobilities µ and the following evaluation standard.
A: The saturation mobility µ was 1.0 cm²/Vs or greater.
B: The saturation mobility µ was 0.1 cm²/Vs or greater and less than 1.0 cm²/Vs.
C: The saturation mobility µ was 0.01 cm²/Vs or greater and less than 0.1 cm²/Vs.
D: The saturation mobility µ was less than 0.01 cm²/Vs.

**[Table 1]**

| | Example 1 | | Example 2 | | Comparative Example 1 | |
|---|---|---|---|---|---|---|
| | Side surfaces: glass material | | Side surfaces UV-treated glass material | | No side surfaces | |
| | Film thickness (nm) | TFT characteristics | Film thickness (nm) | TFT characteristics | Film thickness (nm) | TFT characteristics |
| S₁ | 29 | A | 26 | A | 85 | D |
| S₂ | 38 | A | 35 | A | 150 | D |
| S₃ | 35 | A | 29 | A | 95 | D |
| S₄ | 27 | A | 23 | A | 95 | D |
| S₅ | 45 | B | 35 | A | 100 | C |
| S₆ | 33 | A | 30 | A | 110 | D |
| S₇ | 30 | A | 29 | A | 150 | C |
| S₈ | 38 | A | 33 | A | 75 | B |
| S₉ | 34 | A | 32 | A | 120 | C |
| Average | 34 | A | 30 | A | 109 | D |
| Deviation | 6 | - | 4 | - | 27 | - |

**[Table 2]**

| | Substrate temperature (°C) | Tilt angle (°) | TFT characteristics |
|---|---|---|---|
| Example 3 | 100 | 1 | C |
| Example 4 | 100 | 2 | C |
| Example 5 | 100 | 3 | B |
| Example 6 | 100 | 4 | B |
| Example 7 | 100 | 5 | B |
| Example 8 | 100 | 6 | C |
| Example 9 | 120 | 1 | B |
| Example 10 | 120 | 2 | B |
| Example 11 | 120 | 3 | A |
| Example 12 | 120 | 4 | A |
| Example 13 | 120 | 5 | A |
| Example 14 | 120 | 6 | B |
| Example 15 | 140 | 1 | C |
| Example 16 | 140 | 2 | B |
| Example 17 | 140 | 3 | A |
| Example 18 | 140 | 4 | A |
| Example 19 | 140 | 5 | A |
| Example 20 | 140 | 6 | B |

As listed in Table 1, in Example 1 and Example 2, the film thickness was thin and unevenness in film thickness was small so that a uniform film was obtained, compared to Comparative Example 1. In regard to the TFT characteristics, unevenness in saturation mobility was small and the saturation mobility was uniform. Therefore, the TFT characteristics were excellent. As described above, Example 1 and Example 2, the film thickness was uniform and the uniformity was high so that a high-quality film with excellent TFT characteristics was able to be obtained. In Example 2, the UV treatment was performed on the side surfaces, and thus the wettability of the side surfaces with respect to the raw material solution was higher than that of the side surfaces of Example 1. Therefore, both of the uniformity in film thickness and the uniformity in TFT characteristics were excellent.

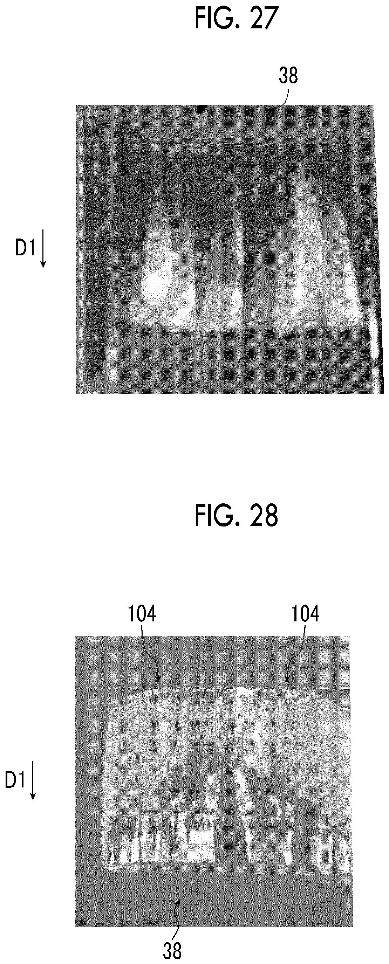

Fig. 27 illustrates the film of Example 1, and Fig. 28 illustrates the film of Comparative Example 1. Figs. 27 and 28 are both photomicrographs obtained by a polarizing microscope.

The uniform film 38 was obtained in Example 1 as illustrated in Fig. 27, but the film 38 which had partially turbid regions 104 and was nonuniform as illustrated in Fig. 28 was formed in Comparative Example 1. The turbid regions 104 were regions where the film thickness was not uniform, the crystal was discontinuous, and the alignment was not made. It was considered that the turbid regions 104 were generated due to extra nucleation caused by repetitive evaporation and dissolution of the raw material solution because side surfaces were not provided.

As listed in Table 2, in Examples 3 to 20, the substrate temperatures were 100°C, 120°C, and 140°C, and in a case where the tilt angle was in a range of 3° to 5° regardless of the substrate temperature, the saturation mobility was further increased and excellent TFT characteristics were obtained.

Further, the results obtained in a case where slide glass having a width of 24 mm or a width of 32 mm was used for the coating blade were not described, but the results were the same as those obtained in a case where the width of the slide glass was 18 mm.

The length of the solution supplied initially was in a range of 10 to 20 mm, which means that the same tendency was obtained.

### Explanation of References

10, 11: coating blade
12: plane portion
12a: facing surface
12c: site
12d: corner portion
13, 92a, 102a: contact side
14, 94: side surface
14b: end surface
16: supply pipe
16a: supply port
30: substrate
30a: surface
30b: rear surface
33: open part
34: liquid reservoir
36: raw material solution
36a: liquid surface
38: film
39: region
40: thin film transistor
42: substrate
42a, 44a, 46a: surface
43: gate electrode
44: insulating film
46: organic semiconductor layer
48a: source electrode
48b: drain electrode
50: coating head
52: support
60, 60a: production device
62: casing
62a: inner portion
64: stage
66: temperature controller
68: driver
70: sensor
72: supply unit
74: guide rail
76: carriage
78: motor
79: control unit
80: unwinding roll
82: winding roll
90, 100: coating blade
92, 102: plane portion
104: region
Bg: film growth interface
Cg: crystal growth portion
D1: first direction
D2: second direction
D3: third direction
D_{B}: direction
D_{F}: direction
G₁: first gap
G₂: second gap
G₃: gap
S, S₁, S₂, S₃, S₄, S₅, S₆, S₇, S₈, S₉: region
θ: tilt angle

## Claims

1. A method of producing a film, comprising:
supplying a raw material solution containing a solvent and a material that forms a film onto a substrate and drying the solvent to form the film on the substrate,
wherein a coating blade holding the raw material solution on the substrate is used,
the coating blade has a facing surface which faces a surface of the substrate and at least one side surface which is provided in the periphery of the facing surface and is in contact with the raw material solution, and
the solvent of the raw material solution is dried along a specific direction to form the film.

2. The method of producing a film according to claim 1,
wherein at least three surfaces, which are the facing surface and two side surfaces of the coating blade, are in contact with the raw material solution.

3. The method of producing a film according to claim 1 or 2,
wherein the specific direction in which the raw material solution is dried is determined by at least one surface from among the facing surface and at least two side surfaces of the coating blade.

4. The method of producing a film according to any one of claims 1 to 3,
wherein the specific direction in which the raw material solution is dried is determined only by one surface from among the facing surface and at least two side surfaces of the coating blade.

5. The method of producing a film according to claim 4,
wherein the specific direction in which the raw material solution is dried is determined only by the facing surface of the coating blade.

6. The method of producing a film according to any one of claims 1 to 5,
wherein the coating blade has two side surfaces, and
two side surfaces are respectively perpendicular to the surface of the substrate and provided so as to face each other.

7. The method of producing a film according to any one of claims 1 to 6,
wherein the facing surface of the coating blade is inclined with respect to the surface of the substrate.

8. The method of producing a film according to claim 7,
wherein a tilt angle of the facing surface of the coating blade with respect to the surface of the substrate is in a range of 1° to 6°.

9. The method of producing a film according to any one of claims 1 to 8,
wherein a film growth interface of the raw material solution held on the substrate by the coating blade is curved toward the center of the raw material solution.

10. The method of producing a film according to any one of claims 1 to 9,
wherein a position of the coating blade is fixed to the surface of the substrate.

11. The method of producing a film according to any one of claims 1 to 9,
wherein the coating blade includes an open part that opens at least a part in the periphery of the raw material solution and the substrate is moved in a direction toward the open part from the center of the raw material solution.

12. The method of producing a film according to claim 11,
wherein the substrate is moved while the raw material solution is supplied to a space between the surface of the substrate and the coating blade so that the film is continuously formed.

13. The method of producing a film according to any one of claims 1 to 12,
wherein, in a case where a boiling point of the solvent of the raw material solution is set as Tb°C and a substrate temperature is set as Ts°C, the substrate temperature Ts is held at a temperature satisfying an expression of "Tb - 50°C ≤ Ts ≤ Tb".

14. The method of producing a film according to any one of claims 1 to 13,
wherein the film is formed of a material having an aligning property.

15. The method of producing a film according to claim 14,
wherein the material having an aligning property is a material or an organic semiconductor that forms a crystal.
